# EUROPEAN PATENT APPLICATION

(11) **EP 4 797 492 A1**
(43) Date of publication of application: **26.08.2026**
(21) Application number: 26155038.8
(22) Date of filing: 29.01.2026
(51) Int. Cl.: H02J 7/50, H02J 7/82, H02J 7/00, H02J 7/90

(54) **ALLOWABLE POWER OR ALLOWABLE CURRENT DECIDING METHOD AND ELECTRIC STORAGE SYSTEM**

(30) Priority: 21.02.2025 JP 2025026445
(71) Applicant: Prime Planet Energy & Solutions, Inc., Chuo-ku, Tokyo 103-0022 (JP)
(72) Inventor: MURAO, Hiroya, Tokyo, 103-0022 (JP); YANO, Junya, Tokyo, 103-0022 (JP); HARADA, Yasuyuki, Tokyo,, 103-0022 (JP)
(74) Representative: Kuhnen & Wacker Patent- und Rechtsanwaltsbüro PartG mbB

(57) **Abstract**

A method for sequentially deciding allowable power or allowable current for charging or discharging of a system (10) including parallel-connected electric storage devices (100) includes: determining allowable power or allowable current for each of the electric storage devices (100) at a present time; estimating a power ratio or current ratio between the electric storage devices (100) at a future time within a predetermined time; and deciding, in accordance with the estimated future power ratio or current ratio, allowable power or allowable current for the system (10) valid until after lapse of the predetermined time such that power or current of each of the electric storage devices (100) is within the allowable power or allowable current for each of the electric storage devices (100) at the present time.

## Description

### BACKGROUND OF THE INVENTION

The present invention relates to allowable power or allowable current deciding methods and electric storage systems.

JP 2022-102034 A, for example, discloses a method for deciding a maximum value for current to be passed during charging or discharging of an electric storage system including storage battery modules connected in parallel. The system disclosed in JP 2022-102034 A calculates resistance values and allowable current values of the storage battery modules so as to decide the maximum value for current to be passed through the system, such that the current value of each storage battery module does not exceed its allowable current value. The system disclosed in JP 2022-102034 A calculates the allowable current value for each storage battery module in accordance with: a state of charge (SOC) calculated from a current integrated value or an open voltage; and a measured temperature.

WO 2019/049571, for example, discloses a method for deciding a state of power (SOP) for charging or discharging of an electric storage system including electric storage racks connected in parallel. The term "state of power" refers to maximum power that enables charging or discharging. The system disclosed in WO 2019/049571 determines an internal resistance and a terminal voltage of each electric storage rack before an operation of the system starts, and predicts, from the determined internal resistance and terminal voltage, current flowing through each electric storage rack at the start of the operation. The system disclosed in WO 2019/049571 thus prevents the current flowing through each electric storage rack at the start of the operation from exceeding its maximum allowable current. After the start of the operation, the system disclosed in WO 2019/049571 measures the current flowing through each electric storage rack with a current sensor.

### SUMMARY OF THE INVENTION

A power ratio and a current ratio between parallel-connected electric storage devices during charging or discharging of the electric storage devices change depending on, for example, the temperature, SOC, and degradation level of each electric storage device. Thus, the power ratio and current ratio during charging or discharging of the parallel-connected electric storage devices change every moment. The present disclosure provides a method for deciding allowable power or allowable current for a system sequentially in consideration of temporal changes in the power ratio and current ratio. The present disclosure also provides an electric storage system that is able to decide allowable power or allowable current for the system in consideration of temporal changes in the power ratio and current ratio.

An allowable power or allowable current deciding method disclosed herein is a method for sequentially deciding allowable power or allowable current for charging or discharging of a system including parallel-connected electric storage devices. The method includes: determining allowable power or allowable current for each of the electric storage devices at a present time; estimating a power ratio or current ratio between the electric storage devices at a future time within a predetermined time; and deciding, in accordance with the estimated future power ratio or current ratio, allowable power or allowable current for the system valid until after lapse of the predetermined time such that power or current of each of the electric storage devices is within the determined allowable power or allowable current for each of the electric storage devices at the present time.

An electric storage system disclosed herein includes: parallel-connected electric storage devices; an allowable value calculator to determine allowable power or allowable current at a present time for charging or discharging of each of the electric storage devices; a ratio estimator to estimate a power ratio or current ratio between the electric storage devices at a future time within a predetermined time; and an allowable value decider to decide, in accordance with the estimated future power ratio or current ratio, allowable power or allowable current for the system valid until after lapse of the predetermined time such that power or current of each of the electric storage devices is within the determined allowable power or allowable current for each of the electric storage devices at the present time.

The method and electric storage system described above estimate the power ratio or current ratio between the electric storage devices at the future time within the predetermined time, and decide, in accordance with the estimated future power ratio or current ratio, the allowable power or allowable current for the system valid until after the lapse of the predetermined time such that the power or current of each of the electric storage devices is within the allowable power or allowable current at the present time. Accordingly, the method and electric storage system described above are able to decide the allowable power or allowable current for the system sequentially in consideration of temporal changes in power ratio and current ratio during charging or discharging of the parallel-connected electric storage devices.

### BRIEF DESCRIPTION OF THE DRAWINGS

Fig. 1 is a schematic diagram of an electric storage system according to an embodiment of the present disclosure.
Fig. 2 is a flow chart illustrating a process for deciding allowable power for a system during charging.
Fig. 3 is a flow chart illustrating process steps to be performed by an ECU in each battery string.
Fig. 4 is a flow chart illustrating a process for updating a current ratio table and calculating a predicted current ratio.
Fig. 5 is a flow chart illustrating the details of a process for deciding allowable power for the system.
Fig. 6 is a graph illustrating an example of temporal changes in SOC of each of two parallel-connected battery strings and temporal changes in current flowing through each battery string.
Fig. 7 is a graph illustrating comparisons between power to be supplied to each battery string when the allowable power is decided by predicting a future power ratio between the battery strings, and power to be supplied to each battery string when the allowable power is decided based on a present power ratio.

### DETAILED DESCRIPTION OF THE PREFERRED EMBODIMENTS

An embodiment of an electric storage system including parallel-connected electric storage devices will be described below. The embodiment described below is not intended to limit the present invention in any way. Each of the drawings is a schematic representation and does not necessarily reflect actual objects to be implemented. In the following description, components and elements similar in function will be identified by common reference signs and, where appropriate, their description will be omitted or simplified to avoid redundancy.

As used herein, the term "electric storage device" refers to any of various devices from which electric energy is derivable. The term "electric storage device" is a concept that subsumes chemical batteries, such as lithium ion secondary batteries and nickel-metal hydride batteries, and physical batteries, such as electric double layer capacitors. Each electric storage device in a phrase such as "parallel-connected electric storage devices" may include series-connected individual devices.

### Configuration of Electric Storage System

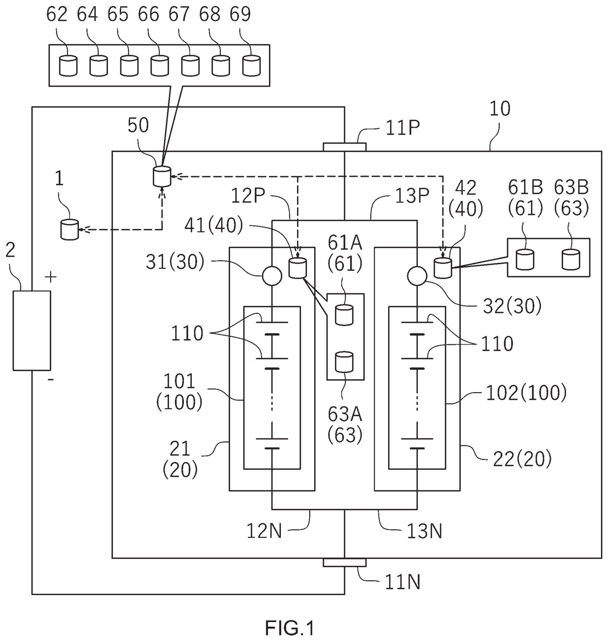

Fig. 1 is a schematic diagram of an electric storage system 10 according to an embodiment of the present disclosure. In the present embodiment, the electric storage system 10 is a vehicle-mounted electric storage system. As illustrated in Fig. 1, the electric storage system 10 communicates with a vehicle control electronic control unit (ECU) 1 to control a vehicle. The electric storage system 10, however, is not limited to a vehicle-mounted electric storage system. The electric storage system 10 may be, for example, an electric storage system which is connected to a commercial power source and whose installation location is fixed. As illustrated in Fig. 1, the electric storage system 10 is connected to an inverter 2. When the electric storage system 10 is to be charged, the inverter 2 converts external alternating-current power (e.g., alternating-current power supplied from an external charging facility) into direct-current power with which the electric storage system 10 is chargeable. When power discharged from the electric storage system 10 is to be used in the vehicle, the inverter 2 converts direct-current power, which is discharged from the electric storage system 10, into alternating-current power.

As illustrated in Fig. 1, the electric storage system 10 includes parallel-connected electric storage devices 100. In the present embodiment, each electric storage device 100 includes series-connected cells 110. Alternatively, the number of cells 110 included in each electric storage device 100 may be one. There is no limit to the number of cells 110 in each electric storage device 100. There is no limit to the type of each cell 110. In one example, each cell 110 is a lithium ion secondary battery. The number of electric devices 100 included in the electric storage system 10 is not specially limited as long as the electric storage system 10 includes two or more electric storage devices 100. Fig. 1 illustrates an example in which the number of electric storage devices 100 included in the electric storage system 10 is two. In the following description, a first electric storage device will be identified by the reference sign 101 and a second electric storage device will be identified by the reference sign 102 when a distinction needs to be made between the two electric storage devices.

As illustrated in Fig. 1, the electric storage system 10 includes battery strings 20. The battery strings 20 each include one electric storage device 100, one ammeter 30, one ECU 40, one or more temperature sensors (not illustrated), and one voltmeter (not illustrated). The ECU 40 included in each battery string 20 may hereinafter be referred to as an "intra-string ECU 40". The battery strings 20 are connected in parallel. In the following description, a first battery string will be identified by the reference sign 21 and a second battery string will be identified by the reference sign 22 when necessary. When necessary, a first ammeter included in the first battery string 21 will be identified by the reference sign 31 and a second ammeter included in the second battery string 22 will be identified by the reference sign 32. When necessary, a first-intra-string ECU included in the first battery string 21 will be identified by the reference sign 41 and a second-intra-string ECU included in the second battery string 22 will be identified by the reference sign 42.

As illustrated in Fig. 1, the electric storage system 10 includes: a positive terminal 11P connected to a positive terminal of the inverter 2; a negative terminal 11N connected to a negative terminal of the inverter 2; a first positive channel 12P connected to a positive terminal of the first battery string 21; a first negative channel 12N connected to a negative terminal of the first battery string 21; a second positive channel 13P connected to a positive terminal of the second battery string 22; and a second negative channel 13N connected to a negative terminal of the second battery string 22. The first positive channel 12P and the second positive channel 13P are connected to the positive terminal 11P. Current flowing through the first positive channel 12P and current flowing through the second positive channel 13P merge to flow through the positive terminal 11P. The first negative channel 12N and the second negative channel 13N are connected to the negative terminal 11N. Current flowing through the negative terminal 11N is distributed to the first negative channel 12N and the second negative channel 13N.

The ammeters 30 each measure current flowing through an associated one of the electric storage devices 100 (i.e., current flowing through an associated one of the battery strings 20). Specifically, the first ammeter 31 measures the current flowing through the first electric storage device 101 (i.e., the current flowing through the first battery string 21). The second ammeter 32 measures the current flowing through the second electric storage device 102 (i.e., the current flowing through the second battery string 22).

The intra-string ECUs 40 each measure the state of an associated one of the electric storage devices 100. The first-intra-string ECU 41 computes various indicators representing the state of the first electric storage device 101 from the current, temperature(s), and voltage respectively measured by the first ammeter 31, the not-illustrated temperature sensor(s), and the not-illustrated voltmeter. The second-intra-string ECU 42 computes various indicators representing the state of the second electric storage device 102 from the current, temperature(s), and voltage respectively measured by the second ammeter 32, the not-illustrated temperature sensor(s), and the not-illustrated voltmeter. The electric storage system 10 includes a master ECU 50 to communicate with the first-intra-string ECU 41 and the second-intra-string ECU 42. The master ECU 50 controls the magnitude and direction of the current to be passed through the electric storage system 10 in accordance with: the computing results of the various indicators received from the first-intra-string ECU 41 and the second-intra-string ECU 42; and a command from the vehicle control ECU 1.

As illustrated in Fig. 1, the master ECU 50, the first-intra-string ECU 41, and the second-intra-string ECU 42 implement an SOC calculator 61, a system SOC calculator 62, an allowable power calculator 63, a current ratio calculator 64, an assumed power setter 65, a system SOC estimator 66, a current ratio estimator 67, an updater 68, and an allowable power decider 69, which function as processors to decide power for charging or discharging of the electric storage system 10. Alternatively, the processors may be implemented by controller(s) other than the ECUs when the electric storage system 10 is not a vehicle-mounted system. The processors are not limited to any particular configuration. The processors may include, for example, a microcomputer. In one example, the microcomputer may include: an interface (I/F) to receive data and/or other information from an external device; a central processing unit (CPU) to execute commands included in a program; a read-only memory (ROM) storing the program to be executed by the CPU; a random-access memory (RAM) used as a working area where the program is to be decompressed; and a storage device (such as a memory) storing the program and various data.

The SOC calculator 61 determines a present SOC of each electric storage device 100. In this embodiment, the SOC calculator 61 includes: a first SOC calculator 61A implemented by the first-intra-string ECU 41; and a second SOC calculator 61B implemented by the second-intra-string ECU 42. The first SOC calculator 61A determines an SOC of the first electric storage device 101. The second SOC calculator 61B determines an SOC of the second electric storage device 102.

The system SOC calculator 62 determines a present representative SOC of the system from the present SOCs of the electric storage devices 101 and 102. In this embodiment, the representative SOC of the system is an average value of the SOCs of the electric storage devices 101 and 102 determined by the SOC calculator 61. The representative SOC of the system, however, is not limited to the average value of the SOCs of the electric storage devices 101 and 102. The representative SOC of the system may be, for example, a median value of the SOCs of the electric storage devices 101 and 102.

The allowable power calculator 63 determines allowable power at a present time for charging or discharging of the electric storage devices 101 and 102. As used herein, the term "allowable power at a present time" refers to maximum power with which the electric storage system 10 at the present time is chargeable or dischargeable continuously for a certain period of time (e.g., a few or several seconds to ten and a few or several seconds). The allowable power at the present time may hereinafter be simply referred to as "allowable power". The allowable power at the present time is set at a value at which voltage of each electric storage device 100 would remain between upper and lower limit voltages if the electric storage system 10 at the present time is charged or discharged continuously for the certain period of time and at which current flowing through each internal component of the electric storage system 10 does not exceed its allowable maximum current. Basically, the allowable power for charging is power determined by multiplying the maximum current (at which voltage of the electric storage devices 101 and 102 do not reach the upper limit voltage) by a terminal voltage. The allowable power for charging is calculated in consideration of the temperature and degradation level (e.g., the rate of increase in resistance value) of each of the electric storage devices 101 and 102. The allowable power for charging of the first electric storage device 101 changes in accordance with the state of the first electric storage device 101. The allowable power for charging of the second electric storage device 102 changes in accordance with the state of the second electric storage device 102. The allowable power for charging of the first electric storage device 101 and the allowable power for charging of the second electric storage device 102 usually differ from each other. The allowable power for charging may be determined by multiplying the maximum current which is responsive to the temperatures, SOCs, and degradation levels of the electric storage devices 101 and 102 by the terminal voltage, or may be determined by entering the temperatures, SOCs, and degradation levels into a table that predefines relationships between the temperatures, SOCs, and degradation levels and the allowable power. The allowable power may be calculated by any of various methods known in the art.

The allowable power for discharging is power at which the electric storage devices 101 and 102 would not reach the lower limit voltage and the allowable current for the components would not be exceeded if the electric storage devices 101 and 102 are discharged continuously for a certain period of time. The allowable power for discharging is calculated in consideration of the temperatures and degradation levels of the electric storage devices 101 and 102. The allowable power for discharging may be calculated by any of various methods known in the art.

In this embodiment, the allowable power calculator 63 includes: a first allowable power calculator 63A implemented by the first-intra-string ECU 41; and a second allowable power calculator 63B implemented by the second-intra-string ECU 42. The first allowable power calculator 63A determines the allowable power for charging or discharging of the first electric storage device 101. The second allowable power calculator 63B determines the allowable power for charging or discharging of the second electric storage device 102.

The current ratio calculator 64 determines a present current ratio between the electric storage devices 101 and 102 from the present current measured by the ammeters 31 and 32. In this embodiment, the current ratio calculator 64 calculates a normalized ratio between the current measured by the first ammeter 31 (i.e., the current flowing through the first electric storage device 101) and the current measured by the second ammeter 32 (i.e., the current flowing through the second electric storage device 102). As used herein, the term "normalized ratio" refers to a ratio normalized such that the sum of constituent values of the ratio equals 1).

The assumed power setter 65 calculates temporary allowable power for the system, which is total allowable power for the electric storage devices 101 and 102 at the present time. In accordance with the calculated temporary allowable power for the system, the assumed power setter 65 sets assumed power that is lower than or equal to the temporary allowable power for the system. In the present embodiment, the assumed power is the temporary allowable power for the system itself. Alternatively, the assumed power may be power determined by, for example, multiplying the temporary allowable power for the system by a safety factor that is smaller than or equal to 1. As described below, the assumed power is power calculated to estimate the ratio of the currents flowing through the electric storage devices 101 and 102 at a future time within a predetermined time (e.g., ten seconds to ten and a few or several seconds) on the assumption that the electric storage system 10 is charged or discharged with this power. As described below, the allowable power decider 69 is configured or programmed to decide the allowable power for the system valid until after the lapse of the predetermined time sequentially.

The system SOC estimator 66 determines an estimated value of the representative SOC of the system at a future time (e.g., at the future time within the predetermined time) when charging or discharging is performed with the assumed power. Specifically, the system SOC estimator 66 determines, from the present SOCs of the electric storage devices 101 and 102 determined by the SOC calculator 61, the estimated values of the SOCs of the electric storage devices 101 and 102 at the future time when charging or discharging is performed with the assumed power. The system SOC estimator 66 determines the estimated value of the representative SOC of the system at the future time from the estimated values of the SOCs of the electric storage devices 101 and 102. In this embodiment, the system SOC estimator 66 determines the estimated value of the representative SOC of the system at the future time by averaging the estimated values of the SOCs of the electric storage devices 101 and 102 at the future time when charging or discharging is performed with the assumed power. The estimated value of the future representative SOC of the system is calculated by subjecting the estimated values of the SOCs of the electric storage devices 101 and 102 to a process (which is an averaging process in this embodiment) similar to that performed for calculation of the present representative SOC of the system.

The current ratio estimator 67 estimates the ratio of the currents flowing through the electric storage devices 101 and 102 at the future time in accordance with: the estimated value of the representative SOC of the system at the future time, which is determined by the system SOC estimator 66; and a previously determined relationship between the representative SOC of the system and the ratio of the currents flowing through the electric storage devices 101 and 102. In the present embodiment, the current ratio estimator 67 estimates the ratio of the currents flowing through the electric storage devices 101 and 102 after the lapse of the predetermined time. Alternatively, the current ratio estimator 67 may estimate the ratios of the currents flowing through the electric storage devices 101 and 102 at future times until after the lapse of the predetermined time.

In the case of charging, for example, the estimated value of the representative SOC of the system after the lapse of the predetermined time is greater than the present representative SOC of the system. In the present embodiment, the relationship between the representative SOC of the system and the ratio of the currents flowing through the electric storage devices 101 and 102 is updated on an as-needed basis in accordance with: the representative SOC of the system determined by the system SOC calculator 62; and current values actually measured by the ammeters 31 and 32. Alternatively, the relationship between the representative SOC of the system and the ratio of the currents flowing through the electric storage devices 101 and 102 may be determined in advance and may remain fixed.

The updater 68 updates the relationship between the representative SOC of the system and the ratio of the currents flowing through the electric storage devices 101 and 102 in accordance with: the present representative SOC of the system determined by the system SOC calculator 62; and the present current ratio determined by the current ratio calculator 64. In the present embodiment, the updated current ratio provided by the updater 68 is a weighted average of the present current ratio determined by the current ratio calculator 64 and a yet-to-be-updated current ratio. The updated current ratio, however, is not limited to the weighted average just mentioned. In one example, the updated current ratio provided by the updater 68 may be the present current ratio determined by the current ratio calculator 64 just as it is.

In the present embodiment, the relationship between the representative SOC of the system and the ratio of the currents flowing through the electric storage devices 101 and 102 is determined for each section that is provided by dividing the representative SOC of the system into sections. The sections are set more broadly (or roughly) than the minimum amount of the SOC processable by the electric storage system 10 (i.e., SOC resolving power). Thus, the computational load is smaller than when the representative SOC of the system is divided into small sections (or smallest possible sections allowed by SOC resolving power) and the ratio of the currents flowing through the electric storage devices 101 and 102 is computed for each of the small sections.

The allowable power decider 69 decides, in accordance with the future current ratio estimated by the current ratio estimator 67, the allowable power for the system valid until after the lapse of the predetermined time such that the power of the electric storage devices 101 and 102 is within the allowable power at the present time. In this embodiment, the allowable power decider 69 decides the allowable power for the system such that the power of both of the electric storage devices 101 and 102 is within the allowable power at the present time when power is distributed to the electric storage devices 101 and 102 in accordance with: the current ratio after the lapse of the predetermined time estimated by the current ratio estimator 67; and the present current ratio determined by the current ratio calculator 64. In this embodiment, the allowable power decider 69 computes the allowable power for the system by using the current ratio calculated by averaging the estimated current ratio after the lapse of the predetermined time and the present current ratio. A method for calculating the allowable power for the system, however, is not limited to a method that involves averaging the future current ratio and the present current ratio. In one example, the allowable power for the system may be calculated by using the larger one of the future current ratio and the present current ratio (i.e., the one that indicates a larger difference between the current flowing through the electric storage device 101 and the current flowing through the electric storage device 102).

### Process for Deciding Allowable Power for System

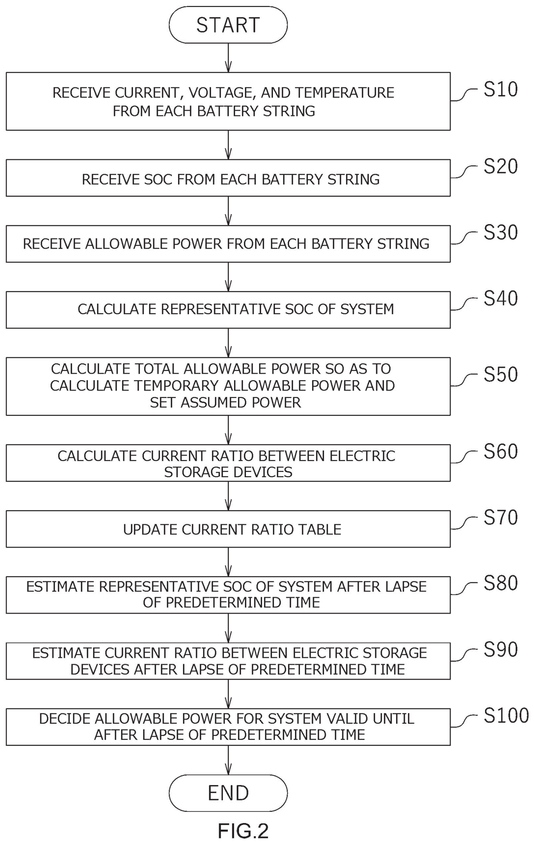

The following description discusses a process for deciding allowable power for the system during charging. A process for deciding allowable power for the system during discharging may be similar to the process for deciding allowable power for the system during charging. Fig. 2 is a flow chart illustrating the process for deciding allowable power for the system during charging. As illustrated in Fig. 2, in step S10 of the process for deciding allowable power for the system, the master ECU 50 receives current, voltage, and temperature measurement results from the first-intra-string ECU 41 and the second-intra-string ECU 42. In step S20, the master ECU 50 receives SOC calculation results from the first-intra-string ECU 41 and the second-intra-string ECU 42. In step S30, the master ECU 50 receives allowable power calculation results from the first-intra-string ECU 41 and the second-intra-string ECU 42.

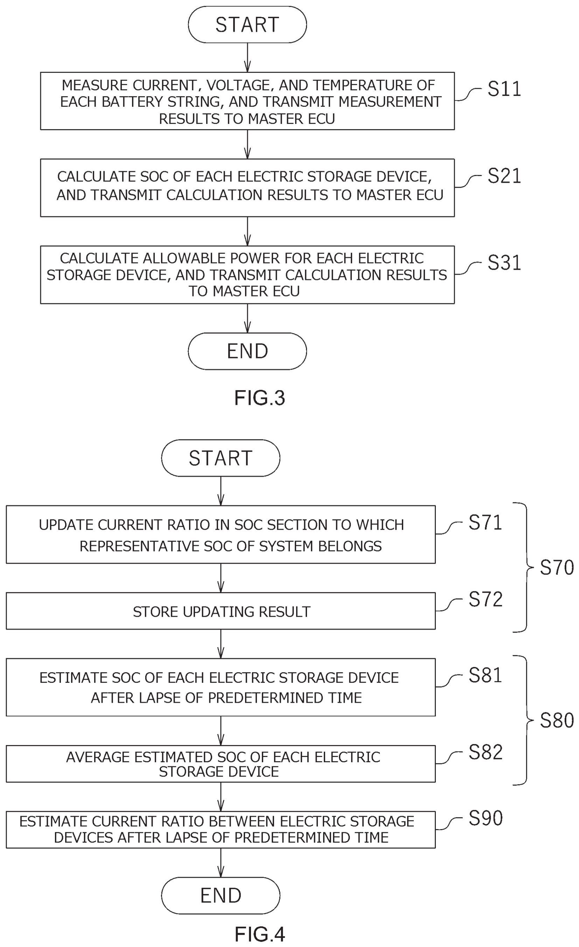

Fig. 3 is a flow chart illustrating process steps to be performed by the intra-battery-string ECUs 41 and 42. As illustrated in Fig. 3, in step S11, the intra-battery-string ECUs 41 and 42 respectively measure the currents, voltages, and temperatures of the battery strings 21 and 22, and transmit the measurement results to the master ECU 50. In step S21, the intra-battery-string ECUs 41 and 42 respectively calculate the SOCs of the electric storage devices 101 and 102, and transmit the calculation results to the master ECU 50. In this embodiment, the SOC of the first electric storage device 101 is a representative value of the SOCs of the cells 110 included in the first electric storage device 101, and the SOC of the second electric storage device 102 is a representative value of the SOCs of the cells 110 included in the second electric storage device 102. In this embodiment, the representative value is an average value. The representative value, however, is not limited to an average value.

In step S31, the intra-battery-string ECUs 41 and 42 calculate allowable power (e.g., allowable power at the present time) for the electric storage devices 101 and 102 when the SOCs of the electric storage devices 101 and 102 are determined, and transmit the calculation results to the master ECU 50. The allowable power for the electric storage devices 101 and 102 varies depending on the temperatures, SOCs, and degradation levels of the electric storage devices 101 and 102. In this embodiment, the allowable power for the electric storage devices 101 and 102 is determined by entering the temperatures, SOCs, and degradation levels into a table that predefines relationships between the temperatures, SOCs, and degradation levels and the allowable power.

Referring back to the Fig. 2, in step S40 of the process for deciding allowable power for the system, the representative SOC of the system is determined from the SOCs of the electric storage devices 101 and 102 received in step S20. In this embodiment, the representative SOC of the system determined in step S40 is an average value of the SOCs of the electric storage devices 101 and 102.

In step S50, temporary allowable power for the system, which is total allowable power for the electric storage devices 101 and 102, is calculated. In step S50, assumed power that is lower than or equal to the temporary allowable power for the system is also set in accordance with the temporary allowable power for the system. In this embodiment, the assumed power set in step S50 is the temporary allowable power for the system.

In step S60, the current ratio (i.e., the present current ratio) is determined between the electric storage devices 101 and 102 when the SOCs of the electric storage devices 101 and 102 are determined. In this embodiment, the master ECU 50 determines the current ratio between the electric storage devices 101 and 102 from the current data received in step S10.

In step S70, the relationship between the representative SOC of the system and the ratio of the currents flowing through the electric storage devices 101 and 102 is updated in accordance with the present representative SOC of the system determined in step S40 and the present current ratio determined in step S60. This updating makes it possible to follow changes in the relationship between the representative SOC of the system and the ratio of the currents flowing through the electric storage devices 101 and 102, which are caused by, for example, changes over time and/or changes in temperature. The relationship between the representative SOC of the system and the ratio of the currents flowing through the electric storage devices 101 and 102 is contained in a current ratio table stored in the master ECU 50. In step S70, the current ratio table is updated.

In step S80, an estimated value of the representative SOC of the system after the lapse of the predetermined time when charging is performed with the assumed power is determined. In step S90, the ratio of the currents flowing through the electric storage devices 101 and 102 after the lapse of the predetermined time is estimated in accordance with: the estimated value of the representative SOC of the system determined in step S80; and the previously determined relationship between the representative SOC of the system and the ratio of the currents flowing through the electric storage devices 101 and 102 (i.e., the relationship updated in step S70 in this embodiment).

Fig. 4 is a flow chart illustrating a process for updating the current ratio table (step S70), calculating a predicted value of the representative SOC of the system (step S80), and calculating a predicted current ratio (step S90). As illustrated in Fig. 4, in sub-step S71 of step S70 for updating the current ratio table, a correspondence between the SOC and current ratio in an SOC section to which the representative SOC of the system belongs is updated. For example, suppose that the SOC of the system is divided into 20 SOC sections as follows: [0%, 5%), [5%, 10%), ..., [95%, 100%), where the symbol "[" represents inclusive and symbol ")" represents exclusive, and that the representative SOC of the system is 42%. In this case, the correspondence between the SOC and current ratio in the SOC section [40%, 45%) is updated.

In the present embodiment, the weighted average of the current ratio (i.e., the present current ratio) between the electric storage devices 101 and 102 when the SOCs of the electric storage devices 101 and 102 are determined and the yet-to-be-updated current ratio is the updated current ratio. There is no limit to weights of the weighted average. A weight assigned to the yet-to-be-updated current ratio may be preferably set to be greater than a weight assigned to the present current ratio. For example, suppose that at the time of measurement, the ratio between the current flowing through the first electric storage device 101 and the current flowing through the second electric storage device 102 is 0.4:0.6 (where the current flowing through the electric storage system 10 is normalized to 1), the yet-to-be-updated current ratio is 0.45:0.55, the weight assigned to the present current ratio is 0.1, and the weight assigned to the yet-to-be-updated current ratio is 0.9. In this case, the updated current ratio is as follows: (0.4 × 0.1 + 0.45 × 0.9):(0.6 × 0.1 + 0.55 × 0.9) = 0.445:0.555. In step S72, the updating result is stored.

The updating of the current ratio table in step S70 does not have to be performed each time the SOC and current ratio calculation is carried out. The updating of the current ratio table in step S70 may be performed after the SOC and current ratio calculation is carried out a predetermined number of times, or may be performed at predetermined time intervals (e.g., daily). "Updating" does not necessarily have to be changing all of the correspondences and may include, for example, a process such as updating a portion of data used in a moving average.

In sub-step S81 of step S80 for estimating the representative SOC of the system, the SOCs of the electric storage devices 101 and 102 after the lapse of the predetermined time when charging is performed with the assumed power is estimated from the SOCs (i.e., the present SOCs) of the electric storage devices 101 and 102 determined in step S21. In sub-step S82, the estimated SOCs are averaged to calculate the estimated value of the representative SOC of the system after the lapse of the predetermined time.

In step S90 for calculating the predicted current ratio, the estimated value of the representative SOC of the system after the lapse of the predetermined time, which is calculated in step S80, is input into the current ratio table (i.e., the current ratio table updated in step S70) to determine the predicted current ratio between the electric storage devices 101 and 102 after the lapse of the predetermined time.

Referring back to Fig. 2, in step S100, the allowable power for the system valid until after the lapse of the predetermined time is decided such that the power of the electric storage devices 101 and 102 is within the allowable power determined in step S31 in accordance with the current ratio after the lapse of the predetermined time estimated in step S90.

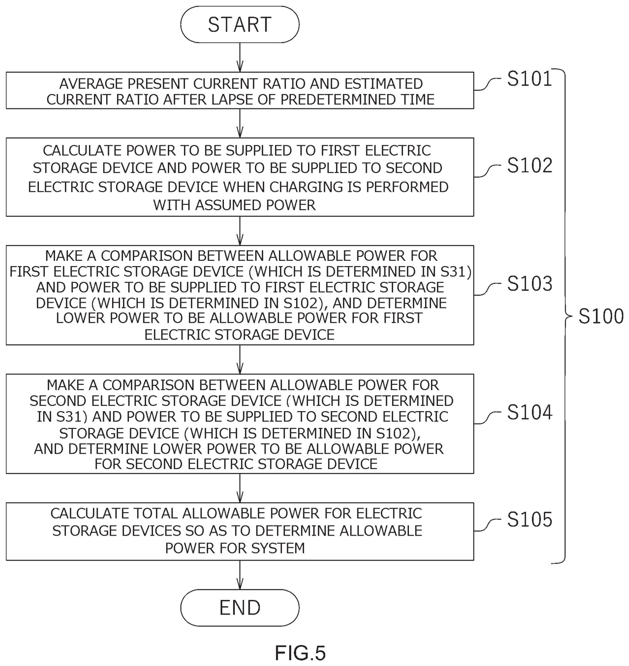

Fig. 5 is a flow chart illustrating the details of a process for deciding the allowable power for the system. As illustrated in Fig. 5, in sub-step S101 of step S100 for deciding the allowable power for the system, the present current ratio determined in step S60 and the current ratio after the lapse of the predetermined time estimated in the step S90 are averaged to calculate the current ratio for use in computation of the allowable power for the system. In one example, in the current ratio averaging process, the normalized present current flowing through the first electric storage device 101 and the normalized estimated current flowing through the first electric storage device 101 after the lapse of the predetermined time are averaged to obtain the normalized current flowing through the first electric storage device 101. In the current ratio averaging process, the normalized present current flowing through the second electric storage device 102 and the normalized estimated current flowing through the second electric storage device 102 after the lapse of the predetermined time are also averaged to obtain the normalized current flowing through the second electric storage device 102. The process of combining the present current ratio and the estimated current ratio after the lapse of the predetermined time, however, is not limited to the averaging process. The process of combining the present current ratio and the estimated current ratio after the lapse of the predetermined time may be, for example, a weighted averaging process with different weights.

In sub-step S102, power to be supplied to the first electric storage device 101 and power to be supplied to the second electric storage device 102 when charging is performed with the assumed power are calculated in accordance with the current ratio calculated in sub-step S101. In sub-step S103, the power to be supplied to the first electric storage device 101 calculated in sub-step S102 and the allowable power for the first electric storage device 101 calculated in step S31 are compared, and the lower power is selected as the allowable power for the first electric storage device 101. In sub-step S104, the power to be supplied to the second electric storage device 102 calculated in sub-step S102 and the allowable power for the second electric storage device 102 calculated in step S31 are compared, and the lower power is selected as the allowable power for the second electric storage device 102.

In sub-step S105, the sum of the allowable power for the first electric storage device 101 determined in sub-step S103 and the allowable power for the second electric storage device 102 determined in sub-step S104 is calculated. The sum is the allowable power for the system valid until after the lapse of the predetermined time. When the allowable power calculated in step S31 is selected as the power to be supplied to either the first electric storage device 101 or the second electric storage device 102 in sub-steps S103 and S104, the power to be supplied to the electric storage devices 101 and 102 corresponds to, by calculation, neither the power to be supplied calculated in sub-step S102, nor the allowable power calculated in step S31. Even in this case, however, the allowable power for the first electric storage device 101 and the allowable power for the second electric storage device 102 are each lower than the allowable power calculated in step S31.

In the present embodiment, the electric storage system 10 measures the currents flowing through the electric storage devices 101 and 102 during charging with the ammeters 31 and 32, respectively. The electric storage system 10 is configured or programmed to, when the current(s) measured by one or more ammeters 30 is/are higher than a current obtained by multiplying a current associated with the allowable power calculated in sub-steps S103 and S104 by a predetermined safety factor (which is smaller than 1), further reduce the allowable power for the system to the power obtained by multiplying the allowable power for the system at this point in time by the safety factor. The electric storage system 10 maintains the allowable power for the system when the currents measured by all of the ammeters 30 are each lower than or equal to the current obtained by multiplying the current associated with the allowable power calculated in sub-steps S103 and S104 by the safety factor.

### Effects of Embodiment

The following description discusses effects achievable by the electric storage system 10 according to the present embodiment and the method for deciding the allowable power for the system.

The electric storage system 10 according to the present embodiment includes: the parallel-connected electric storage devices 101 and 102; the allowable power calculator 63 to determine the allowable power at the present time for charging or discharging of the electric storage devices 101 and 102; the current ratio estimator 67 to estimate the current ratio between the electric storage devices 101 and 102 at the future time within the predetermined time (i.e., after the lapse of the predetermined time); and the allowable power decider 69 to decide, in accordance with the estimated future current ratio, the allowable power for the system valid until after the lapse of the predetermined time such that the power of the electric storage devices 101 and 102 is within the determined allowable power for the electric storage devices 101 and 102 at the present time.

The power ratio during charging or discharging of the parallel-connected electric storage devices changes depending on, for example, the SOC, temperature, and degradation level of each electric storage device. Thus, the power ratio during charging or discharging of the parallel-connected electric storage devices changes every moment. The electric storage system 10 according to the present embodiment estimates the current ratio between the electric storage devices 101 and 102 at the future time within the predetermined time, and decides, in accordance with the estimated current ratio, the allowable power for the system valid until after the lapse of the predetermined time such that the power of the electric storage devices 101 and 102 is within the allowable power at the present time. Accordingly, the electric storage system 10 is able to decide the allowable power sequentially in consideration of temporal changes in power ratio during charging or discharging of the parallel-connected electric storage devices 101 and 102.

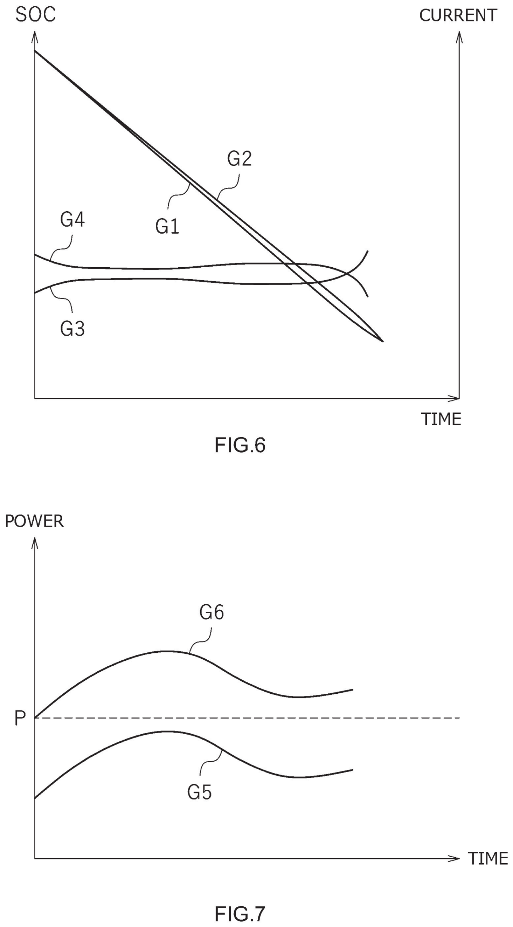

Fig. 6 is a graph illustrating an example of temporal changes in SOC of each of two parallel-connected battery strings and temporal changes in current flowing through each battery string. The vertical axis in Fig. 6 represents the SOCs and current values. The horizontal axis in Fig. 6 represents time. A graph G1 represents temporal changes in the SOC of a first one of electric storage devices. A graph G2 represents temporal changes in the SOC of a second one of the electric storage devices, which is connected in parallel to the first one of the electric storage devices. A graph G3 represents one example of temporal changes in the current flowing through the first one of the electric storage devices. A graph G4 represents one example of temporal changes in the current flowing through the second one of the electric storage devices. As illustrated in Fig. 6, during discharging of the two parallel-connected electric storage devices, the current flowing through the first one of the electric storage devices and the current flowing through the second one of the electric storage devices usually exhibit different behaviors. The current ratio between the parallel-connected electric storage devices is decided in accordance with: an internal resistance ratio between the electric storage devices (e.g., a ratio between the total sums of resistance values of components, such as cells and inter-cell busbars, which are included in the electric storage devices); and a difference between the SOCs of the electric storage devices. The internal resistances of the cells change depending on the temperatures, SOCs, and degradation levels of the cells. The internal resistance of each cell usually increases as its temperature decreases and its degradation proceeds. The internal resistances of the cells also change depending on the SOCs of the cells. If the full charge capacities of the parallel-connected electric storage devices differ owing to degradation and individual differences of the cells, the SOC of the electric storage device with the lower capacity decreases earlier, resulting in a difference between the SOCs of the electric storage devices. This causes current to flow from the electric storage device with the higher SOC (i.e., the higher voltage) to the electric storage device with the lower SOC (i.e., the lower voltage), resulting in a current difference between the electric storage devices. The current ratio between the electric storage devices changes every time depending on individual differences, temperature differences, SOC differences, and degradation level differences among a large number of cells included in the parallel-connected electric storage devices. Thus, if, for example, the internal resistances and terminal voltages of the parallel-connected electric storage devices are measured before charging or discharging and then allowable power is decided in accordance with the measurements, the current flowing through a part of the electric storage devices may exceed true allowable current.

In the present embodiment, the future current ratio between the electric storage devices 101 and 102 is estimated, and the allowable power is decided in accordance with the estimated current ratio. Accordingly, if the ratio between the current flowing through the first electric storage device 101 and the current flowing through the second electric storage device 102 changes with the lapse of time, the currents flowing through the electric storage devices 101 and 102 would be unlikely to exceed the true allowable current.

Fig. 7 is a graph illustrating comparisons between power to be supplied to each battery string when the allowable power is decided by predicting a future power ratio between the battery strings, and power to be supplied to each battery string when the allowable power is decided based on a present power ratio. The vertical axis in Fig. 7 represents power. The horizontal axis in Fig. 7 represents time. A graph G5 represents one example of temporal changes in the power to be supplied to each electric storage device when the allowable power is decided by predicting the future power ratio between the battery strings. A graph G6 represents one example of temporal changes in the power to be supplied to each electric storage device when the allowable power is decided based on the present power ratio. As used herein, "allowable power" refers to power that is allowed to be fed continuously for a certain period of time (e.g., 10 seconds) from the present time. When the electric storage devices are not connected in parallel, the allowable power determined for each electric storage device remains valid after the lapse of time. When the electric storage devices are connected in parallel, however, the future power ratio changes depending on the relationship between one electric storage device and another electric storage device connected in parallel. The electric storage system 10 according to the present embodiment solves this problem.

As illustrated in Fig. 7, when the allowable power is decided based on the present power ratio, the power to be supplied to each electric storage device does not exceed true allowable power P at the beginning of charging but may exceed the true allowable power P owing to changes in the current ratio afterward. When the allowable power is decided by predicting the future power ratio between the battery strings, the power to be supplied to each electric storage device is expected to increase owing to changes in the current ratio, and the allowable power is thus minimized in advance, with the result that the power to be supplied to each electric storage device would be unlikely to exceed the true allowable power P if the current ratio changes afterward. The temporal changes in the power illustrated in Fig. 7 are only illustrative.

In the above-described embodiment, the allowable power valid until after the lapse of the predetermined time is decided by using the predicted current ratio after the lapse of the predetermined time as the predicted future current ratio. The predicted future current ratio is not limited to the predicted current ratio after the lapse of the predetermined time. The predicted future current ratio may include predicted current ratios at future times within a predetermined time. In this case, the allowable power decider 69 may decide the allowable power for the system such that the power of all of the electric storage devices 101 and 102 is within the allowable power at the present time, which is determined by the allowable power calculator 63, when current is distributed to the electric storage devices 101 and 102 in accordance with the largest maximum-to-minimum current ratio among estimated future current ratios. This makes it possible to more reliably prevent the currents flowing through the electric storage devices 101 and 102 from exceeding the true allowable current.

The electric storage system 10 according to the present embodiment further includes the assumed power setter 65 to set the assumed power that is lower than or equal to the total allowable power for the electric storage devices 101 and 102 at the present time. The current ratio estimator 67 estimates the future current ratio when charging or discharging is performed with the assumed power. The allowable power for the system valid until after the lapse of the predetermined time includes an error. If the allowable power for the system which exceeds the actual allowable power is determined due to this error, the determined allowable power may exceed the upper and lower limit voltages of the electric storage devices 101 and 102 and/or the allowable current for the components. The present embodiment is able to reduce the possibility of occurrence of this problem by using the assumed power set to be lower than or equal to the total allowable power for the electric storage devices 101 and 102 at the present time.

The electric storage system 10 according to the present embodiment further includes: the SOC calculator 61 to determine the present SOCs of the electric storage devices 101 and 102; and the system SOC estimator 66 to determine, from the present SOCs of the electric storage devices 101 and 102 determined by the SOC calculator 61, the estimated values of the future SOCs of the electric storage devices 101 and 102 when charging or discharging is performed with the assumed power, and to determine the estimated value of the future representative SOC of the system from the estimated values of the SOCs of the electric storage devices 101 and 102. The current ratio estimator 67 estimates the future current ratio in accordance with: the estimated value of the determined future representative SOC of the system; and the previously determined relationship (in this embodiment, the current ratio table) between the representative SOC of the system and the ratio of the currents flowing through the electric storage devices 101 and 102. This makes it possible to more accurately estimate the current ratio between the electric storage devices 101 and 102 by using the current ratio table based on actual measurements.

Alternatively, the current ratio for use in allowable power calculation may be a current ratio other than the one estimated by using the current ratio table, such as a current ratio obtained by multiplying the present current ratio by a safety factor (e.g., multiplying the maximum current by a safety factor greater than 1 such that the maximum-to-minimum current ratio increases).

The electric storage system 10 according to the present embodiment further includes: the ammeters 31 and 32 to measure the currents flowing through the electric storage devices 101 and 102, respectively; the system SOC calculator 62 to determine the present representative SOC of the system from the present SOCs of the electric storage devices 101 and 102 determined by the SOC calculator 61; the current ratio calculator 64 to determine the present current ratio between the electric storage devices 101 and 102 from the present currents measured by the ammeters 31 and 32; and the updater 68 to update the relationship between the representative SOC of the system and the ratio of the currents flowing through the electric storage devices 101 and 102 in accordance with the present representative SOC of the system determined by the system SOC calculator 62 and the present current ratio determined by the current ratio calculator 64. The electric storage system 10 is able to continuously cope with temporal changes, temperature changes, and so forth of the electric storage devices 101 and 102 by updating, in accordance with the measured values, the relationship between the representative SOC of the system and the ratio of the currents flowing through the electric storage devices 101 and 102.

In the present embodiment, the allowable power decider 69 decides the allowable power for the system such that the power of all of the electric storage devices 101 and 102 is within the allowable power at the present time determined by the allowable power calculator 63 when power is distributed to the electric storage devices 101 and 102 in accordance with the estimated future current ratio and the present current ratio determined by the current ratio calculator 64. In the present embodiment, the allowable power for the system is decided in accordance with both of the estimated current ratio after the lapse of the predetermined time and the present current ratio. With this embodiment, the allowable power for the system is decided also in consideration of the present current ratio, thus, suitable allowable power for the system is obtained during many time periods between the present time and the end of the predetermined time.

The allowable power decider 69 may decide the allowable power for the system such that the power of all of the electric storage devices 101 and 102 is within the allowable power determined by the allowable power calculator 63 when power is distributed to the electric storage devices 101 and 102 in accordance with only the estimated future current ratio.

In the present embodiment, the relationship between the representative SOC of the system and the ratio of the currents flowing through the electric storage devices 101 and 102 is determined for each section that is provided by dividing the representative SOC of the system into sections. This makes the computational load smaller than when the representative SOC of the system is divided into small sections and the ratio of the currents flowing through the electric storage devices 101 and 102 is computed for each of the small sections.

In the present embodiment, the representative SOC of the system is the average value of the determined SOCs of the electric storage devices 101 and 102. This makes it possible to obtain the representative SOC of the electric storage system 10 suitably representative of the SOCs of the electric storage devices 101 and 102 by performing an averaging process.

### Other Embodiments

One embodiment of the electric storage system and the method for deciding the allowable power for the electric storage system, which are disclosed herein, has been described above. The above-described embodiment, however, is provided by way of example only. The present disclosure may be embodied in various other forms.

In one example, the allowable power for the system may be decided by: determining predicted power to be supplied (or discharged) to each electric storage device when a certain level of power is supplied (or discharged) to the electric storage system; and repeatedly making a determination of whether or not the predicted power exceeds the allowable power. The determination is repeatedly made, with the power level being increased until the predicted power exceeds the allowable power for a battery string. The electric storage system may decide the allowable power for the system by multiplying the power thus calculated by a safety factor.

In the above-described embodiment, the safety factor by which the calculated allowable power is multiplied remains fixed. Alternatively, the safety factor may be changed in accordance with the predicted current ratio. In one example, when the current flowing through one or more of parallel-connected electric storage devices is lower than the current flowing through the other electric storage device(s) by a certain amount, degradation of the electric storage device(s) through which the lower current flows may proceed, which may result in a sudden change in resistance(s) and/or capacity(ies) of the electric storage device(s). Thus, if the current ratio between the parallel-connected electric storage devices (e.g., the ratio of the maximum current to the minimum current) exceeds a predetermined value, the safety factor may be set to be higher than when the current ratio does not exceed the predetermined value. The safety factor may be changed in a step-by-step manner (e.g., in three or more steps) or in a continuous manner in accordance with the current ratio between the parallel-connected electric storage devices. When the electric storage system is a vehicle-mounted electric storage system, the safety factor is preferably changed in a situation in which fluctuations in power conditions are slight (e.g., during charging by an external charging and discharging facility) rather than in a situation in which fluctuations in power conditions are significant (e.g., during travel). Alternatively, there is no limit to the timing to change the safety factor.

In this specification, the terms "power", "current", "allowable power (for a system or an electric storage device)", "(predicted or present) current ratio", "temporary allowable power", and "assumed power" may be respectively replaced with the terms "current", "power", "allowable current (for a system or an electric storage device)", "(predicted or present) power ratio", "temporary allowable current", and "assumed current", unless any particular problem arises. In the above-described embodiment, a step that involves determining current or using a current value for computation may be replaced with a step that involves determining power or using a power value for computation. In the above-described embodiment, a step that involves determining power or using a power value for computation may be replaced with a step that involves determining current or using a current value for computation. It is optional whether to further calculate power from current and whether to further calculate current from power.

Unless explicitly described otherwise, the above-described embodiment does not limit the scope of the invention. Various changes may be made to the techniques disclosed herein. Unless any particular problem arises, one or more of the components, elements, and processes mentioned herein may be omitted or combined each other as appropriate. This specification includes the disclosure of items described below.

### Item 1

A method for sequentially deciding allowable power or allowable current for charging or discharging of a system including parallel-connected electric storage devices, the method comprising:
determining allowable power or allowable current for each of the electric storage devices at a present time;
estimating a power ratio or current ratio between the electric storage devices at a future time within a predetermined time; and
deciding, in accordance with the estimated future power ratio or current ratio, allowable power or allowable current for the system valid until after lapse of the predetermined time such that the decided power or current of each of the electric storage devices is within the determined allowable power or allowable current for each of the electric storage devices at the present time.

### Item 2

The allowable power or allowable current deciding method according to item 1, further comprising setting assumed power that is lower than or equal to total allowable power at the present time for the electric storage devices, or assumed current that is lower than or equal to total allowable current at the present time for the electric storage devices, wherein
the estimating the future power ratio or current ratio includes estimating the future power ratio or current ratio when charging or discharging is performed with the assumed power or assumed current.

### Item 3

The allowable power or allowable current deciding method according to item 2, further comprising:
determining a present SOC of each of the electric storage devices; and
determining, from the determined present SOC of each of the electric storage devices, an estimated value of an SOC of each of the electric storage devices at the future time when charging or discharging is performed with the assumed power or assumed current, and determining, from the estimated value of the SOC of each of the electric storage devices, an estimated value of a representative SOC of the system at the future time, wherein
the estimating the power ratio or current ratio includes estimating the future power ratio or current ratio in accordance with the determined estimated value of the future representative SOC of the system and a previously determined relationship between the representative SOC of the system and the power ratio or current ratio between the electric storage devices.

### Item 4

The allowable power or allowable current deciding method according to item 3, further comprising:
determining a present representative SOC of the system from the present SOC of each of the electric storage devices;
determining a present power ratio or current ratio between the electric storage devices; and
updating the relationship between the representative SOC of the system and the power ratio or current ratio between the electric storage devices in accordance with the determined present representative SOC of the system and the determined present power ratio or current ratio.

### Item 5

The allowable power or allowable current deciding method according to items 3 or 4, wherein
the relationship between the representative SOC of the system and the power ratio or current ratio between the electric storage devices is determined for each section that is provided by dividing the representative SOC of the system into sections.

### Item 6

The allowable power or allowable current deciding method according to any one of items 3 to 5, wherein
the representative SOC of the system is an average value of the determined SOCs of the electric storage devices.

### Item 7

The allowable power or allowable current deciding method according to any one of items 1 to 6, wherein
the deciding the allowable power or allowable current for the system includes deciding the allowable power or allowable current for the system such that power or current of all of the electric storage devices is within the determined allowable power or allowable current for the electric storage devices at the present time when power or current is distributed to the electric storage devices in accordance with a largest maximum-to-minimum power ratio or current ratio among the estimated future power ratios or current ratios.

### Item 8

The allowable power or allowable current deciding method according to any one of items 1 to 7, further comprising determining a present power ratio or current ratio between the electric storage devices, wherein
the deciding the allowable power or allowable current for the system includes deciding the allowable power or allowable current for the system such that power or current of all of the electric storage devices is within the determined allowable power or allowable current for the electric storage devices at the present time when power or current is distributed to the electric storage devices in accordance with the estimated future power ratio or current ratio and the determined present power ratio or current ratio.

### Item 9

An electric storage system comprising:
parallel-connected electric storage devices;
an allowable value calculator to determine allowable power or allowable current at a present time for charging or discharging of each of the electric storage devices;
a ratio estimator to estimate a power ratio or current ratio between the electric storage devices at a future time within a predetermined time; and
an allowable value decider to decide, in accordance with the estimated future power ratio or current ratio, allowable power or allowable current for the system valid until after lapse of the predetermined time such that power or current of each of the electric storage devices is within the determined allowable power or allowable current for each of the electric storage devices at the present time.

### Item 10

The electric storage system according to item 9, further comprising an assumed value setter to set assumed power that is lower than or equal to total allowable power at the present time for the electric storage devices, or assumed current that is lower than or equal to total allowable current at the present time for the electric storage devices, wherein
the ratio estimator estimates the future power ratio or current ratio when charging or discharging is performed with the assumed power or assumed current.

### Item 11

The electric storage system according to item 10, further comprising:
an SOC calculator to determine a present SOC of each of the electric storage devices; and
a system SOC estimator to determine, from the determined present SOC of each of the electric storage devices, an estimated value of an SOC of each of the electric storage devices at the future time when charging or discharging is performed with the assumed power or assumed current, and to determine, from the estimated value of the SOC of each of the electric storage devices, an estimated value of a representative SOC of the system at the future time, wherein
the ratio estimator estimates the future power ratio or current ratio in accordance with the determined estimated value of the future representative SOC of the system and a previously determined relationship between the representative SOC of the system and the power ratio or current ratio between the electric storage devices.

### Item 12

The electric storage system according to item 11, further comprising:
measuring devices to measure the power or current of the electric storage devices;
a system SOC calculator to determine a present representative SOC of the system from the present SOC of each of the electric storage devices determined by the SOC calculator;
a ratio calculator to determine a present power ratio or current ratio between the electric storage devices from the power or current measured by each of the measuring devices; and
an updater to update the relationship between the representative SOC of the system and the power ratio or current ratio between the electric storage devices in accordance with the present representative SOC of the system determined by the system SOC calculator and the present power ratio or current ratio determined by the ratio calculator.

### Item 13

The electric storage system according to items 11 or 12, wherein
the relationship between the representative SOC of the system and the power ratio or current ratio between the electric storage devices is determined for each section that is provided by dividing the representative SOC of the system into sections.

### Item 14

The electric storage system according to any one of items 11 to 13, wherein
the representative SOC of the system is an average value of the determined SOCs of the electric storage devices.

### Item 15

The electric storage system according to any one of items 9 to 14, wherein
the allowable value decider decides the allowable power or allowable current for the system such that power or current of all of the electric storage devices is within the determined allowable power or allowable current for the electric storage devices at the present time when power or current is distributed to the electric storage devices in accordance with a largest maximum-to-minimum power ratio or current ratio among the estimated future power ratios or current ratios.

### Item 16

The electric storage system according to any one of items 9 to 15, further comprising:
measuring devices to measure the power or current of the electric storage devices; and
a ratio calculator to determine a present power ratio or current ratio between the electric storage devices from the power or current measured by each of the measuring devices, wherein
the allowable value decider decides the allowable power or allowable current for the system such that power or current of all of the electric storage devices is within the determined allowable power or allowable current for the electric storage devices at the present time when power or current is distributed to the electric storage devices in accordance with the estimated future power ratio or current ratio and the determined present power ratio or current ratio.

## Claims

1. A method for sequentially deciding allowable power or allowable current for charging or discharging of a system (10) including parallel-connected electric storage devices (100), the method comprising:
determining allowable power or allowable current (S30) for each of the electric storage devices (100) at a present time;
estimating a power ratio or current ratio (S90) between the electric storage devices (100) at a future time within a predetermined time; and
deciding, in accordance with the estimated future power ratio or current ratio, allowable power or allowable current (S100) for the system (10) valid until after lapse of the predetermined time such that the decided power or current of each of the electric storage devices (100) is within the determined allowable power or allowable current for each of the electric storage devices (100) at the present time.

2. The allowable power or allowable current deciding method according to claim 1, further comprising setting assumed power (S50) that is lower than or equal to total allowable power at the present time for the electric storage devices (100), or assumed current that is lower than or equal to total allowable current at the present time for the electric storage devices (100), wherein
the estimating the future power ratio or current ratio (S90) includes estimating the future power ratio or current ratio when charging or discharging is performed with the assumed power or assumed current.

3. The allowable power or allowable current deciding method according to claim 2, further comprising:
determining a present SOC (S20) of each of the electric storage devices (100); and
determining, from the determined present SOC of each of the electric storage devices (100), an estimated value of an SOC (S81) of each of the electric storage devices (100) at the future time when charging or discharging is performed with the assumed power or assumed current, and determining, from the estimated value of the SOC of each of the electric storage devices (100), an estimated value of a representative SOC of the system (10) at the future time (S80), wherein
the estimating the power ratio or current ratio (S90) includes estimating the future power ratio or current ratio in accordance with the determined estimated value of the future representative SOC of the system (10) and a previously determined relationship between the representative SOC of the system (10) and the power ratio or current ratio between the electric storage devices (100).

4. The allowable power or allowable current deciding method according to claim 3, further comprising:
determining a present representative SOC (S40) of the system (10) from the present SOC of each of the electric storage devices (100);
determining a present power ratio or current ratio (S60) between the electric storage devices (100); and
updating the relationship (S70) between the representative SOC of the system (10) and the power ratio or current ratio between the electric storage devices (100) in accordance with the determined present representative SOC of the system (10) and the determined present power ratio or current ratio.

5. The allowable power or allowable current deciding method according to claims 3 or 4, wherein
the relationship between the representative SOC of the system (10) and the power ratio or current ratio between the electric storage devices (100) is determined for each section that is provided by dividing the representative SOC of the system (10) into sections.

6. The allowable power or allowable current deciding method according to any one of claims 3 to 5, wherein
the representative SOC of the system (10) is an average value of the determined SOCs of the electric storage devices (100).

7. The allowable power or allowable current deciding method according to any one of claims 1 to 6, wherein
the deciding the allowable power or allowable current (S100) for the system (10) includes deciding the allowable power or allowable current for the system (10) such that power or current of all of the electric storage devices (100) is within the determined allowable power or allowable current for the electric storage devices (100) at the present time when power or current is distributed to the electric storage devices (100) in accordance with a largest maximum-to-minimum power ratio or current ratio among the estimated future power ratios or current ratios.

8. The allowable power or allowable current deciding method according to any one of claims 1 to 7, further comprising determining a present power ratio or current ratio (S60) between the electric storage devices (100), wherein
the deciding the allowable power or allowable current (S100) for the system (10) includes deciding the allowable power or allowable current for the system (10) such that power or current of all of the electric storage devices (100) is within the determined allowable power or allowable current for the electric storage devices (100) at the present time when power or current is distributed to the electric storage devices (100) in accordance with the estimated future power ratio or current ratio and the determined present power ratio or current ratio.

9. An electric storage system (10) comprising:
parallel-connected electric storage devices (100);
an allowable value calculator (63) to determine allowable power or allowable current at a present time for charging or discharging of each of the electric storage devices (100);
a ratio estimator (67) to estimate a power ratio or current ratio between the electric storage devices (100) at a future time within a predetermined time; and
an allowable value decider (69) to decide, in accordance with the estimated future power ratio or current ratio, allowable power or allowable current for the system (10) valid until after lapse of the predetermined time such that power or current of each of the electric storage devices (100) is within the determined allowable power or allowable current for each of the electric storage devices (100) at the present time.

10. The electric storage system (10) according to claim 9, further comprising an assumed value setter (65) to set assumed power that is lower than or equal to total allowable power at the present time for the electric storage devices (100), or assumed current that is lower than or equal to total allowable current at the present time for the electric storage devices (100), wherein
the ratio estimator (67) estimates the future power ratio or current ratio when charging or discharging is performed with the assumed power or assumed current.

11. The electric storage system (10) according to claim 10, further comprising:
an SOC calculator (61) to determine a present SOC of each of the electric storage devices (100); and
a system SOC estimator (66) to determine, from the determined present SOC of each of the electric storage devices (100), an estimated value of an SOC of each of the electric storage devices (100) at the future time when charging or discharging is performed with the assumed power or assumed current, and to determine, from the estimated value of the SOC of each of the electric storage devices (100), an estimated value of a representative SOC of the system (10) at the future time, wherein
the ratio estimator (67) estimates the future power ratio or current ratio in accordance with the determined estimated value of the future representative SOC of the system (10) and a previously determined relationship between the representative SOC of the system (10) and the power ratio or current ratio between the electric storage devices (100).

12. The electric storage system (10) according to claim 11, further comprising:
measuring devices (30) to measure the power or current of the electric storage devices (100);
a system SOC calculator (62) to determine a present representative SOC of the system (10) from the present SOC of each of the electric storage devices (100) determined by the SOC calculator (61);
a ratio calculator (64) to determine a present power ratio or current ratio between the electric storage devices (100) from the power or current measured by each of the measuring devices (30); and
an updater (68) to update the relationship between the representative SOC of the system (10) and the power ratio or current ratio between the electric storage devices (100) in accordance with the present representative SOC of the system (10) determined by the system SOC calculator (62) and the present power ratio or current ratio determined by the ratio calculator (64).

13. The electric storage system (10) according to claims 11 or 12, wherein
the relationship between the representative SOC of the system (10) and the power ratio or current ratio between the electric storage devices (100) is determined for each section that is provided by dividing the representative SOC of the system (10) into sections.

14. The electric storage system (10) according to any one of claims 11 to 13, wherein
the representative SOC of the system (10) is an average value of the determined SOCs of the electric storage devices (100).

15. The electric storage system (10) according to any one of claims 9 to 14, wherein
the allowable value decider (69) decides the allowable power or allowable current for the system (10) such that power or current of all of the electric storage devices (100) is within the determined allowable power or allowable current for the electric storage devices (100) at the present time when power or current is distributed to the electric storage devices (100) in accordance with a largest maximum-to-minimum power ratio or current ratio among the estimated future power ratios or current ratios.

16. The electric storage system (10) according to any one of claims 9 to 15, further comprising:
measuring devices (30) to measure the power or current of the electric storage devices (100); and
a ratio calculator (64) to determine a present power ratio or current ratio between the electric storage devices (100) from the power or current measured by each of the measuring devices (30), wherein
the allowable value decider (69) decides the allowable power or allowable current for the system (10) such that power or current of all of the electric storage devices (100) is within the determined allowable power or allowable current for the electric storage devices (100) at the present time when power or current is distributed to the electric storage devices (100) in accordance with the estimated future power ratio or current ratio and the determined present power ratio or current ratio.
